(19) Europäisches Patentamt
European Patent Office
Office européen des brevets

(11) EP 0 574 097 B1

(12) **EUROPEAN PATENT SPECIFICATION**

(45) Date of publication and mention
of the grant of the patent:
**16.12.1998 Bulletin 1998/51**

(51) Int Cl.6: **H01L 23/532**, H01L 23/528

(21) Application number: **93202460.7**

(22) Date of filing: **14.03.1990**

(54) **Semiconductor device having multilayer wiring and the method of making it**

Halbleitervorrichtung mit Mehrlagenverdrahtung und Verfahren zu ihrer Herstellung

Dispositif semi-conducteur ayant un câblage à plusieurs couches et procédé de sa fabrication

(84) Designated Contracting States:
**GB**

(30) Priority: **14.03.1989 JP 61556/89**

(43) Date of publication of application:
**15.12.1993 Bulletin 1993/50**

(62) Document number(s) of the earlier application(s) in
accordance with Art. 76 EPC:
**90302719.1 / 0 388 179**

(73) Proprietor: **KABUSHIKI KAISHA TOSHIBA
Kawasaki-shi, Kanagawa-ken 210 (JP)**

(72) Inventors:
• **Noguchi, Tatsuo, c/o Intellectual Property Div.
Tokyo (JP)**

• **Yoshida, Masayuki, c/o Intellectual Property Div.
Tokyo (JP)**
• **Hatanaka, Kazuhisa,
c/o Intellectual Property Div.
Tokyo (JP)**
• **Tanaka, Shigeru, c/o Intellectual Property Div.
Tokyo (JP)**

(74) Representative: **Waldren, Robin Michael et al
MARKS & CLERK,
57-60 Lincoln's Inn Fields
London WC2A 3LS (GB)**

(56) References cited:
**EP-A- 0 133 023          EP-A- 0 248 266
EP-A- 0 270 184          EP-A- 0 317 161**

EP 0 574 097 B1

## Description

This invention generally relates to semiconductor devices and more specifically to improvements in wiring for LSIs.

In general, the wiring used in LSIs can be devided into the main power source wiring for supplying power to the elements, power source branch wiring that connects the power source main wiring with the individual elements, and signal wiring that transmits signals between the elements. This wiring is normally made of a material whose main constituent is aluminium (Al), but some very short signal wires may be of monocrystalline silicon, a refractory metal or a refractory metal silicide etc.

In memories, part of the diffusion layer may be utilized for wiring; multiple layers of polycrystalline silicon (partly, a refractory metal silicide) are sometimes employed as wiring. Alternatively, wiring using new materials such as copper (Cu) may be employed.

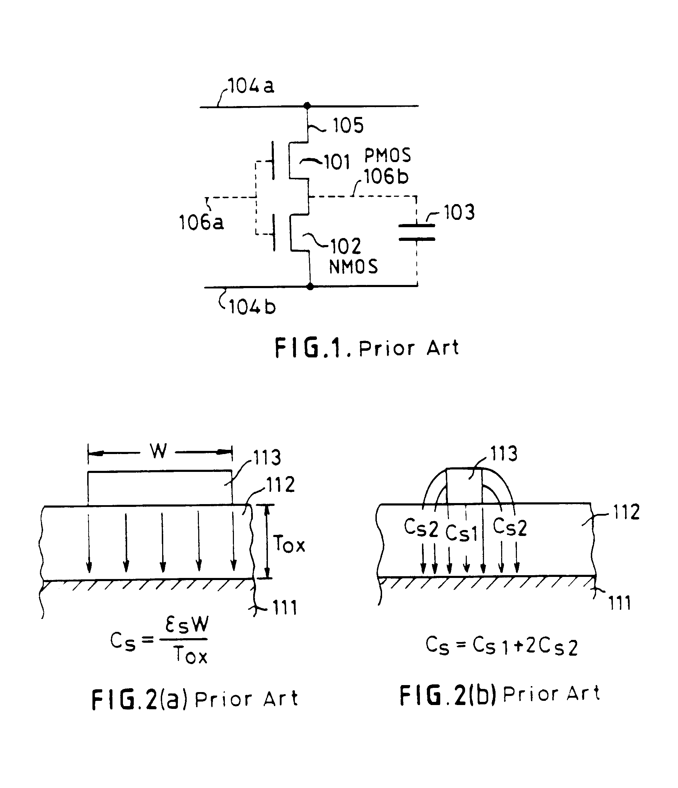

Furthermore, gate arrays or CPUs etc, or the logic LSIs of recent years are formed using metallic wiring layers consisting of at least two layers, in order to increase the degree of circuit integration. Fig. 1 shows diagrammatically, using the case of a CMOS inverter circuit, the difference between signal wiring, power source main wiring, and power source branch wiring. In Fig. 1, reference numerals 104a and 104b indicate power source main wiring, reference numeral 105 indicates power source branch wiring and reference numerals 106a and 106b indicate signal wiring. Power source main wiring 104a and 104b and power source branch wiring 105 normally have d.c. current flowing in them on application of a d.c. voltage, or have a d.c. pulse current flowing in them which is turned on or off with FET elements 101, 102. In general, these currents flow in one direction. In contrast, signal wires 106a and 106b, particularly in a CMOS LSI, have bidirectional pulse current flowing in them produced by charging and discharging of capacitive load. The metal used in multi-layer wirings is exclusively aluminium or an alloy thereof. Even in a layout in which multi-layer wiring is used, different wiring materials were not been used for particular power source main wiring 104a and 104b and signal wiring 106 and 106b.

When current flows in Al wiring of a conventional semiconductor device, so-called electromigration occurs, wherein Al atoms migrate under the influence of the electric current flowing. This may even result in disconnection of the circuit. Since this electromigration increases with current density, the problem becomes much more marked when the wiring is made finer. To prevent this, it is usual to make power source main wiring, in which large current flows, of greater wiring width. However in devices in which the size of the wiring is the limiting factor to reducing area, as in the case of logic LSIs, there has been the problem that the size of such devices could not be reduced. This problem has appeared with advances in miniaturization in signal wiring and power source branch wiring, since, from the point of view of obtaining a high degree of circuit integration, they should be thin, but, from the point of view of current dendity, they need to be wide.

Also, there has been a problem regarding the capacitance Cs per unit of wiring length. As shown in Fig. 2a, when the wiring is of some minimum width, the capacitance is determined by the wiring width W and the film thickness between wiring 113 and substrate 111. However, when miniaturization of the elements requires reduced wiring width W, as shown in Fig. 2b, the capacitance $Cs_2$ between the side faces of wiring 113 and the substrate 111 becomes important. In order to reduce the capacitance and thereby increase the speed of LSIs, it is desirable to increase the thickness of the film between the wiring and substrate, but in general this is difficult since such a method runs counter to element miniaturization. For this reason, the aim is normally to lower capacitance by making the width of the wiring and the film thickness small. Thus, in order to obtain high degrees of circuit integration, the wiring of the signal wiring is made of the minimum workable dimensions.

However, this has led to the problem that, when A1 was used as the material of the wiring, such minimum workable dimensions could not be used for the wiring dimensions, because of electromigration. Consideration was therefore given to increasing resistance to electromigration by using materials other than A1 for the wiring. However, materials of high resistance to electromigration, such as refractory metals such as tungsten or refractory metal silicides, in general have an electrical resistance several orders of magnitude higher than that of A1. It was therefore difficult to employ these materials for signal wires, where the propagation delay of the signal is critical. Therefore they could only be used for wiring of very short length.

In the earlier European patent application EP-A-0 317 161, which belongs to the state of the art in the sense of Article 54(3) and (4) EPC, different materials are used for word and bit lines in a memory device.

Accordingly, an object of this invention is to provide a semiconductor device having multilayer wiring and the method of making it whereby a high degree of integration and high speed can be achieved, as well as high reliability.

This object is achieved according to the present invention by providing a new and improved semiconductor device including multilayer wiring for providing power and control signals to elements of said device, the multilayer wiring being divided into a first wiring layer comprising only signal wiring designed to transmit bidirectional signals to at least one element;

and a second wiring layer comprising only main power source wiring designed to supply power to a plurality of elements of said semiconductor device, wherein the material used to form the main power source wiring has a higher resistance to electromigration than the material used to form the signal wiring.

Alternatively, the above object is achieved according to the present invention by providing a new and improved method of making a semiconductor device including the steps of:

forming a first wiring layer for bidirectional signal wiring only;
forming an insulating layer on said first wiring layer; and
forming a second wiring layer above said first wiring layer for carrying direct current power signals, wherein said second wiring layer is formed of a material having a lower resistance to electromigration than that of the material used to form said first wiring layer.

A more complete appreciation of the invention and many of the attendant advantages there of will be readily obtained as the same becomes better understood from the following detailed description given given by way of example only and with reference to the accompanying drawings, wherein:

Figure 1 is a circuit diagram of a CMOS inverter;
Figure 2a and 2b are views given in explanation of wiring capacitance;
Figure 3a through 3f show fabrication of wiring layers in accordance with a first example of a semiconductor device which does not form part of this invention;
Figure 4a and 4b are cross-sectional view of a semiconductor device of the first example shown in Figure 3f;
Figure 5 is an equivalent circuit diagram of the semiconductor device of the first example;
Figure 6a through 6h show fabrication of wiring layers in accordance with a second example of a semiconductor device which does not form part of this invention;
Figure 7a and 7b are cross-sectional view of a semiconductor device of the second example shown in Figure 6h;
Figure 8 is an equivalent circuit diagram of the semiconductor device of the second example shown in Figure 6;
Figure 9 is a graph showing the test results of a comparison of resistance to electromigration in which a.c. and d.c. currents respectively were allowed to flow in the wiring;
Figure 10 is a cross-sectional view showing an example of a semiconductor device which does not form part of this invention;
Figure 11 is a cross-sectional view showing an embodiment of the semiconductor device according to this invention; and
Figure 12 is a cross-sectional view showing another example of a semiconductor device which does not form part of this invention.

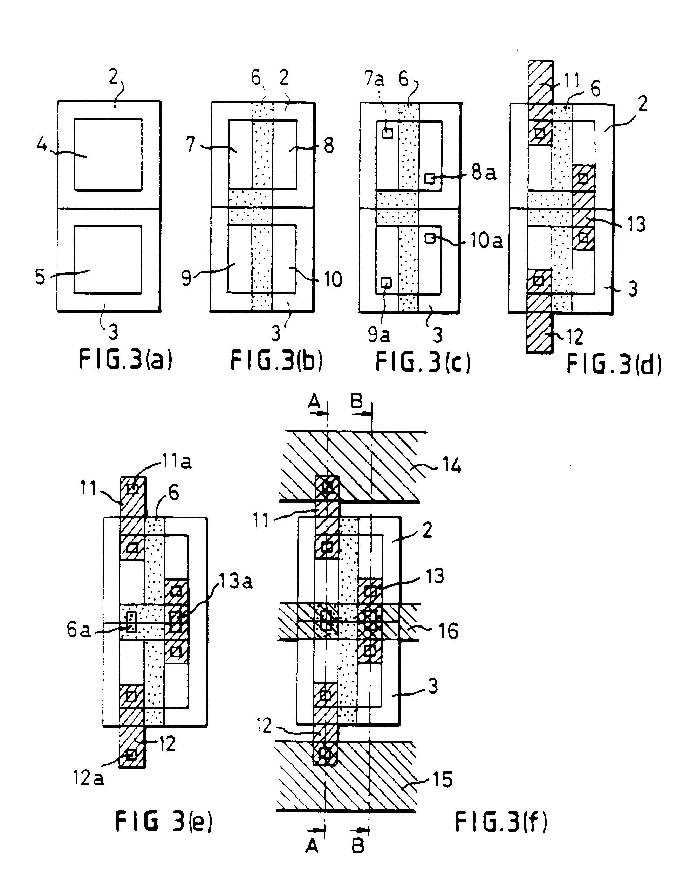

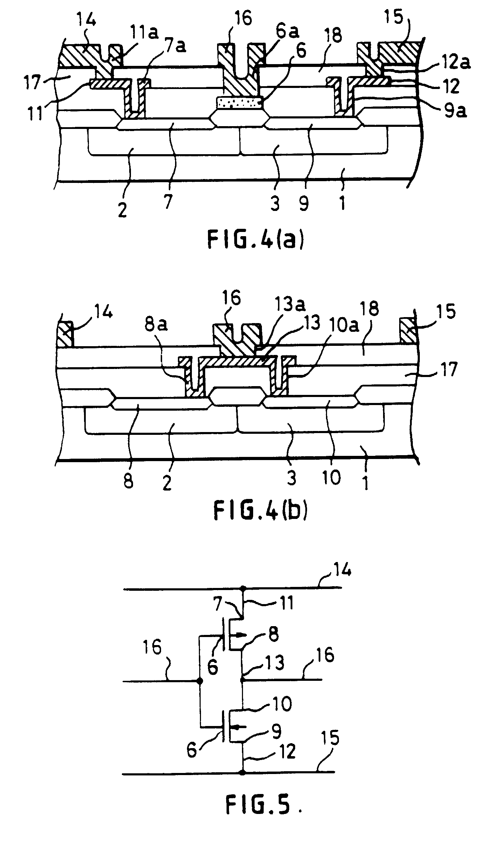

A first example of a semiconductor devicewhich does not form part of this invention is described with reference to the formation of a CMOS inverter shown in Fig. 3 and Fig. 4.

Respective element regions 4 and 5 are formed in N well region 2 and P well region 3 each formed on a monocrystalline silicon substrate 1 (see Fig. 3a). A thick silicon oxide film is formed separating element regions 4 and 5 by the normally-used selective oxidation method employing a silicon nitride film. Next, gate oxide film of 15 nm for example is formed on element regions 4 and 5 and doping with impurity is effected in order to obtain the required threshold voltage values. A polycrystalline silicon layer is then deposited over the entire surface and the polycrystalline silicon layer is made conductive by introducing phosphorus. After this, gate electrodes 6 are formed by patterning the polycrystalline silicon layer as shown in Fig. 3b. Then, boron is introduced into the portions of the element region on N well 2 where gate electrode 6 is not formed, and arsenic is introduced into the portions in the element region on P well 3 where gate electrode 6 is not formed, to form a P channel transistor with source 7 and drain 8 and N channel transistor source 9 and drain 10 (see Fig. 3b).

Then a first silicon oxide film 17 (see Figs. 4a and 4b) is deposited to a thickness of 1 $\mu$m over the entire surface, and is formed with respective connection holes 7a, 9a and 8a, 10a to sources 7,9 and drains 8,10 (see Fig. 3c). Next, a material of high resistance to electromigration, for example tungsten, is deposited in a thickness of 1 micron over the entire surface, and power source branch wires 11, 12 and signal wires 13 are formed as shown in Fig. 3d by patterning. Next, a silicon oxide film 18 (see Figs. 4a and 4b) is deposited in a thickness of 1 $\mu$m over the entire surface, and connection holes 11a, 12a and 13a with power source branch wires 11 and 12 and signal wire 13, as well as connection hole 6a to the gate electrode are formed (see Fig. 3e). Next, power source main wires 14 and 15 and signal wire 16 are formed (see Fig. 3f) by patterning after sputtering a first 1 $\mu$m thick layer of A1 over the entire surface.

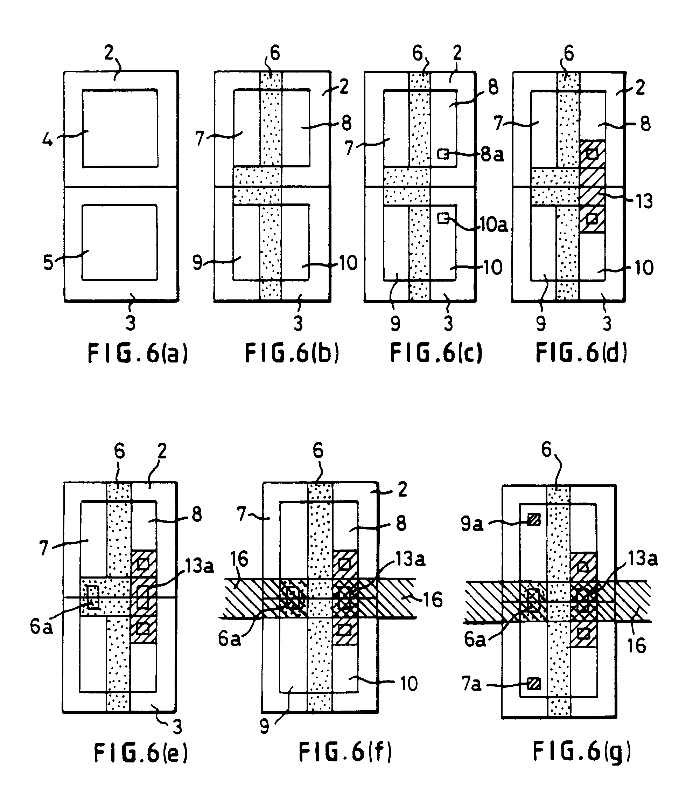

Fig. 4a shows the cross-section along the line A-A of Fig. 3f, and Fig. 4b shows the cross-section along the line B-B of Fig. 3f. Fig. 5 shows the equivalent circuit of the CMOS inverter shown in Fig. 3f. Reference numerals 11, 12 and 13 are power source branch wires 11 and 12 and signal wire 13 respectively, shown by thick lines in Fig. 5.

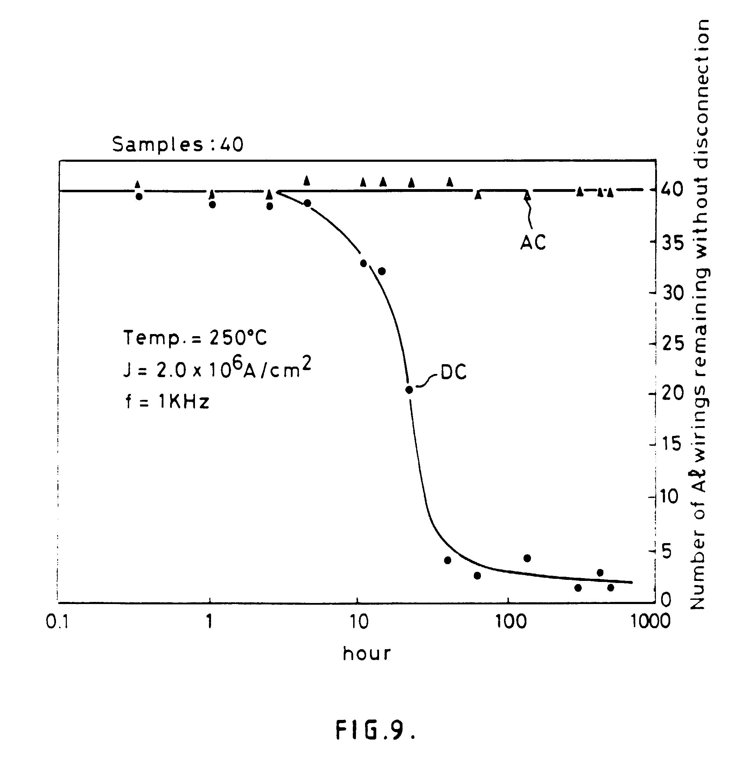

The signal wire is the wiring that transmits the signals between the elements (for example, the drain of one element and the gate electrode of another element). There are a large number of these wires having connections with the miniaturized transistors, and they must be of the same size as the transistors. Although bidirectional current flows in the CMOS signal wire, according to experimental results (see Fig. 9), the resistance to electromigration of the wiring in which bidirectional current flows is, in terms of lifetime, about two orders of magnitude longer than that of wiring in which one directional current flows, i.e., in terms of allowed current, about one order of magnitude greater. That is, wiring in which bidirectional current flows can be made one order of magnitude narrower than wiring in which an equivalent d.c. current flows and experience a similar lifetime. The experimental data in Fig. 9 shows results for the case in which the ambient temperature is 250 C, the current density J is $2.0 \times 10^6$ A/cm$^2$, and the frequency f of the a.c. is 1 kHz.

As described above, with this example, a high degree of circuit integration and high speed circuit operation can be obtained by using Al, which has low resistance and can easily be worked for small sized wiring such as wire 16 in which bidirectional current flows. Also, miniaturization can be achieved and high reliability obtained by using tungsten, which is not susceptible to electromigration, for the power source branch wires 11, 12 and signal wire 13, in which one directional current flows. Power source branch wires 11, 12 and signal wire 13 can be made short, so the voltage drop due to the resistance of the tungsten (about one order of magnitude higher than that of Al) can be practically neglected, and does not interfere with obtaining increased speed of operation.

There is a considerable problem regarding electromigration in the power source main wire since a large one directional current flows in this wire due to the high degree of circuit integration of present day LSI. However, since the power source main wiring need not directly connect to the elements, this wire can be made a separate layer from the other wiring since there is no need for miniaturization of this wire. In this example, Al is used, but there is no particular restriction on the kind of material which can be used.

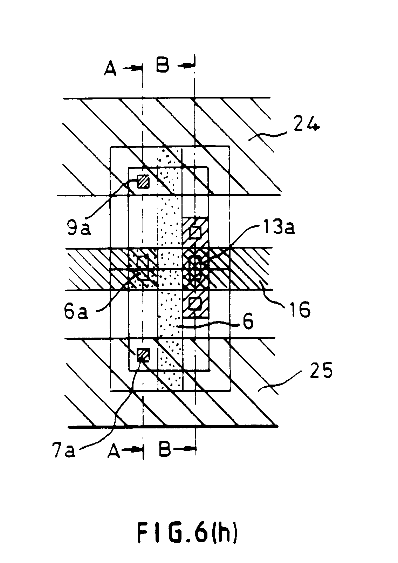

A second example of a semiconductor device which does not form part of this invention will now be described with reference to Fig. 6 through Fig. 8.

Respective element regions 4 and 5 are formed (Fig. 6a) in N well region 2 and P well region 3 formed on single-crystal silicon substrate 1. This can be achieved by the normally employed selective oxidation method using a silicon nitride film, a thick film of silicon oxide being formed in regions other than the element regions 4 and 5. Next, on element regions 4 and 5, a gate oxide film of for example 15 nm thickness is formed, and impurities are introduced to obtain the required threshold voltages. A polycrystalline silicon film is then deposited over the entire surface, and this polycrystalline silicon layer is rendered conductive by doping with phosphorus. As shown in Fig. 6b, gate electrodes 6 are then formed by patterning the polycrystalline silicon film. Next, by doping with boron the parts of the element region on N well 2 that are not formed with gate electrode 6, and doping with arsenic the parts of the element region on P well 3 that are not formed with gate electrode 6, source 7 and drain 8 of the P channel transistors and source 9 and drain 10 of the N channel transistors are formed (see Fig. 6b).

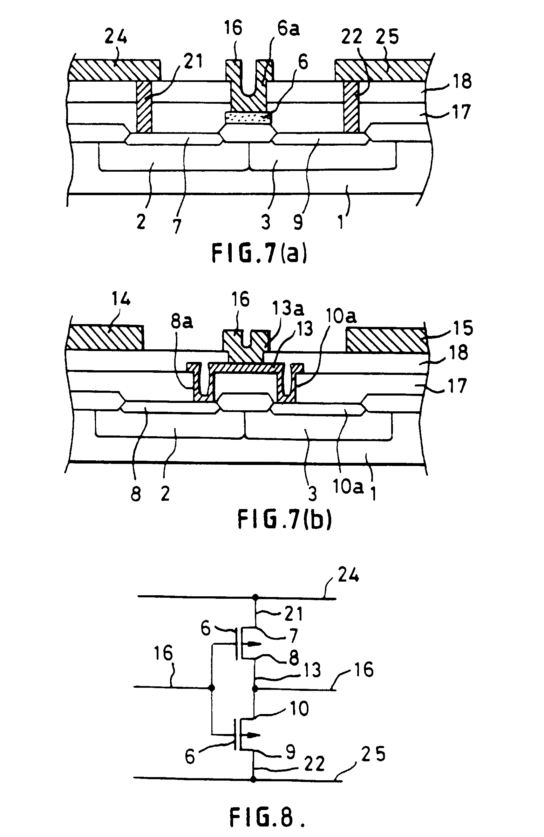

Then a silicon oxide film 17 (see Fig. 7a and 7b) is deposited in a thickness of 1 μm over the entire surface, and connection holes 8a and 10a with the drains 8 and 10 are formed (see Fig. 6c). Next, a material of high resistance to electromigration, such as for example, tungsten, is deposited in a thickness of 1 μm over the entire surface, and signal wires 13 are formed by patterning as shown in Fig. 6d. Next, a silicon oxide film 18 (see Fig. 7a and 7b) is deposited in a thickness of 1 micron over the entire surface, and is formed with connection holes 13a and 6a with the gate electrodes (see Fig. 6e). Then, Al is sputtered to a thickness of 1 micron over the entire surface, and signal wires 16 are formed by patterning (see Fig. 6f).

Next, a silicon oxide film (not shown) is deposited in a thickness of about 1 μm over the entire surface, and is formed with connection holes 7a and 9a with sources 7 and 9. Then perpendicular wiring 21 and 22 is formed of tungsten by depositing tungsten so that only the openings are filled with tungsten (see Fig. 6g and Fig. 7a and 7b). Next, power source wires 24 and 25 are formed by patterning (see Fig. 6h) after depositing an Al film of 1 micron thickness over the entire surface.

Fig. 7a shows a cross-section along with the line A-A, and Fig. 7b shows a cross-section along the line B-B of Fig. 6h. Fig. 8 shows an equivalent circuit of the semiconductor device shown in Fig. 6h. Reference numerals 21, 22 and 13 are respectively power source branch wires 21, 22 and signal wire 13, shown by thick lines.

As described above, tungsten, which is of high resistance to electromigration, is used for power source branch wires 21 and 22, and for signal wire 13, in which one directional current flows, while Al, which can easily be worked for small sized wiring, and is of low resistance, is used for signal wire 16, in which bidirectional current flows. In this way, the semiconductor device of this example can provide the same benefits as that of the first example.

It should be noted that, while in the first and second examples tungsten was used as the material of high resistance to electromigration, the same benefits could be obtained by the use of other refractory metals, refractory metal silicides or copper.

Also, although Al was used for power source main wires 14, 15, 24, and 25, other conductive materials could be used.

In the case of the examples of Fig. 3 and Fig. 4, a CMOS inverter was shown as an example. However, similar fabrication steps could also be applied to other circuits such other logic circuit elements like NAND or NOR gates.

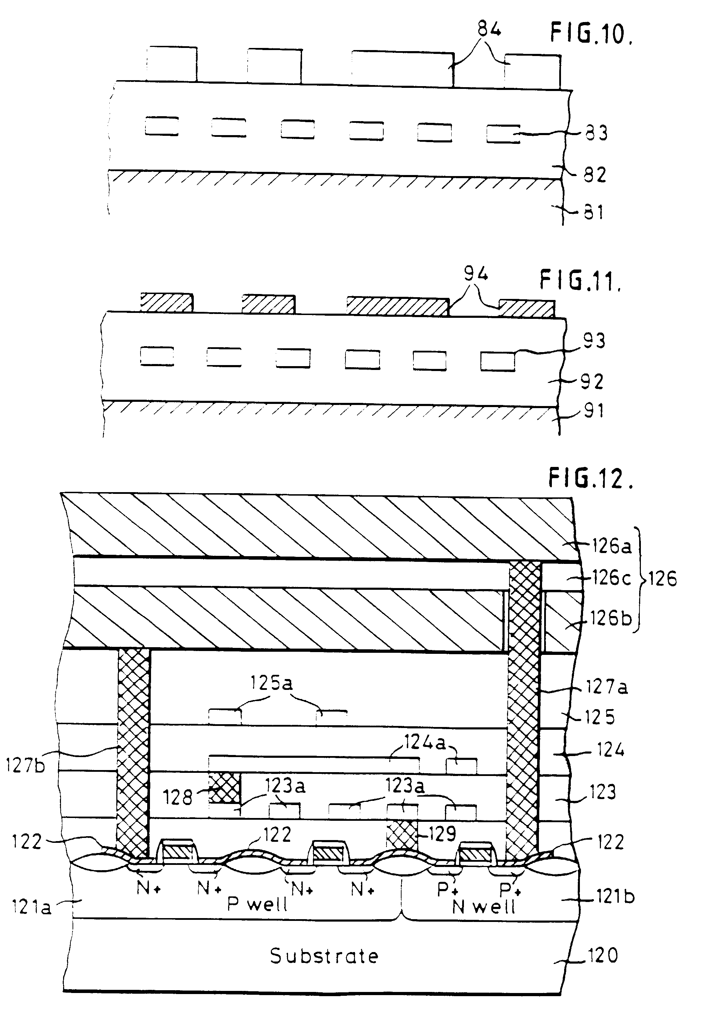

An example of a semiconductor device including a multilayer wiring according to another example is described with reference to Fig. 10.

When a LSI is implemented using multi-layer wiring, the insulating film below each wiring layer needs to be flat, and therefore, in general thin film thickness and miniaturization is especially important in the lower wiring layers. Consequently, as shown in Fig. 10, the wiring of the first layer is thin so that signal delays due to the resistance of the wiring do not cause any problem, and wiring of the minimum workable dimensions is used; thus it consists of a wiring layer 83 used for signal wire only. The resistance of aluminium wiring is much lower than the ON resistance of a transistor, so even if it is made very thin, its resistance rarely presents a problem. For the power source main wire, the second wiring layer 84 and subsequent layers are used. This wiring layer 84 is made sufficiently thick so that it can adequately withstand electromigration under one directional current. Of course, signal wires can also be wired into this wiring layer 84.

As described above, with this example, by separating the signal wires and power source main wires in the layout, a smaller film thickness can be employed for the wiring layer used for the signal wire than for that used for the power source main wire. This makes it possible to produce a high speed LSI, since the capacitance of the signal wires can thereby be reduced. Also, by using thin signal wire in the first wiring layer fine working is facilitated, and flatness of the film between the layer also becomes easier to achieve. This results in an improvement in the degree of integration and yield of the LSIs.

In general, the life of wiring determined by electromigration (MTF) is expressed by:

$$MTF = J^{-2} \exp(-Ea/kT)$$

where J is the current density, Ea is the activation energy, k is the Boltzmann constant, and T is the absolute temperature. From the experimental results described above and shown in Fig. 9, it can be seen that the electromigration lifetime of wiring in which a.c. current flows is at least one hundred times longer than the lifetime of wiring subjected to d.c. current. From the above equation, this means that, in a wiring construction that is optimized in terms of a.c. pulse life (i.e. an optimally thin film is used), the current density of d.c. current would have to be less than 1/10 the current density of a.c. current for the same lifetime to be obtained.

Consequently, the same effect as in the above example can be obtained by setting a d.c. current component in the a.c. current to less than about 1/10 of an a.c. component in the a.c. current.

In cases where a material other than aluminium (or alloys thereof) is used as the metal employed in the multilayer wiring, different materials can be employed in the signal wire and power source wire. Such a case in accordance with the invention is shown in Fig. 11. In Fig. 11, aluminium is used for signal wire 93, in which bidirectional current flows, and tungsten is used for power source main wire 94. For signal wire 93, a material is desirable that has electrical resistance that is as low as possible, even though it has low resistance to electromigration. This enables a high speed LSI to be implemented by reducing the wiring capacitance. In contrast, material of high resistance to electromigation is desirably used for power source main wire 94. This is because a large current can be made to flow to the elements in a restricted region, and a high speed, high reliability LSI is thereby produced. Desirably, as the material of the signal wire, aluminium or copper is used and, as the material of the power source wire, metals such as tungsten, commonly called refractory metals, are used. In this way, the same benefit as in the above described example can be obtained.

Also, in the case where the signal wire and power source main wire are made of different materials, and a material of higher resistance to electromigration is used for the power source main wire than is used for the signal wire, the density of circuit integration can be increased, since the power source main wire can also be miniaturized.

An example of a semiconductor device including a multilayer wiring is described with reference to Fig. 12.

A wiring layer including of a power source branch wire 122 is formed on a plurality of element regions formed in a P well region 121a and an N well region 121b formed on a semiconductor substrate 120. After this, wiring layers 123, 124 and 125 including of signal wires 123a, 124a and 125a is respectively formed on the power source branch wire 122, in that order, and the wiring layer 126 including of power source main wires 126a and 126b are formed on the wiring layer 125. An insulating layer 126c insulates the power source main wire 126a which a high voltage $V_{DD}$ is applied from the power source main wire 126b to which a ground voltage $V_{SS}$ is applied. These power source main wires 126a and 126b cover the entire surface of wiring layer 125 except through hole regions, bonding pad regions and a region for monitoring signals into semiconductor device, etc. and for which is not necessary to be covered by the power source main wire. The power source main wires 126a and 126b are electrically connected with the power source branch wire 122 by power source branch wire 127a and 127b, which is formed of tungsten, for example. Also, a signal wire 123a is electrically connected with a signal wire 124a by a signal wire 128 constituted of tungsten, for example, buried in the through hole, and with the power source branch wire 122 by a signal wire 129 constituted of tungsten, for example, buried in the through hole. Further, the power source branch wire 122 is constituted of a refractory metal or silicide of noble metals.

In general, because of a high degrees of circuit integration, i.e. miniaturization of the elements, a power source voltage tends to be low to reduce reliability problems of the elements. This makes the logical amplitude of signals transmitted in the signal wire low. Also, because of a high performance of the elements, the high frequency signals are used as signals transmitted the signal wires. The low logical amplitude and the high frequency signals decrease the margin for noise from outside.

In the above described example, however, the wiring layer 126 including the power source main wire is separated by and formed on the wiring layer 123, 124 and 125 including the signal wire, and the signal wires 123a, 124a and 125a are covered by the power source main wires 126a and 126b. Since the outer noise which affect the signal transmitted in the signal wires 123a, 124a and 125a is completly shielded by the power source main wires 126a and 126b, and the signal wire is covered by the power source main wire, it is possible to prevent the noise margin from decreasing, to flow the high frequency signal used in the high performance element through the signal wire, and the semiconductor device of this example can obtain high performance and high reliability.

Also, because the power source main wires 126a and 126b can be formed on the entire surface of the wiring layer except for the predetermined regions, the power source main wires 126a and 126b can be thickened, and the semiconductor device of this example can realize that the resistance to electromigration of the power source main wire is higher than the resistance to electromigration of the conventional semiconductor device.

Furthermore, in case of a power source being connected with the elements, the power source main wire may be connected with the elements by power source branch wires 127a and 127b including of tungsten, for example, buried in the through hole as shown in Fig. 12. Thereby, it is possible to save labor for the layout and design of the semiconductor device as compared with other semiconductor device.

As described above, with this invention, a semiconductor device of a higher degree of circuit integration, improved speed and high reliability can be obtained.

## Claims

1. A semiconductor device including multilayer wiring for providing power and control signals to elements of said device, the multilayer wiring being divided into a first wiring layer comprising

   only signal wiring (93) designed to transmit bidirectional signals to at least one element; and a second wiring layer comprising only main power source wiring (94) designed to supply power to a plurality of elements of said semiconductor device;

   wherein

   the material used to form the main power source wiring (94) has a higher resistance to electromigration than the material used to form the signal wiring (93).

2. A semiconductor device according to claim 1, wherein the resistivity of the wiring layer comprising only the signal wiring (93) is lower than the wiring layer comprising the main power source wiring (94).

3. A semiconductor device according to claim 1, wherein the wiring layer comprising the main power source wiring (126a, 126b) covers the surface of the multilayer wiring.

4. A semiconductor device according to claim 1, wherein said first wiring layer (93) is located under said second wiring layer (94).

5. A method of fabricating a semiconductor device having multilayer wiring for providing power and control signals to elements of said device, comprising the steps of:

   forming a first wiring layer (94) for bidirectional signal wiring only; forming an insulating layer (92) on said first wiring layer (94); and forming a second wiring layer (93) above said first wiring layer (94) for carrying direct current power signals, whereby said second wiring layer (93) is formed of a material having a lower resistance to electromigration than that of the material used to form said first wiring layer (94).

## Patentansprüche

1. Halbleitervorrichtung mit einer Mehrschichtverdrahtung zum Liefern von Leistungs- und Steuersignalen an Elemente der Vorrichtung, wobei die Mehrschichtverdrahtung in eine erste Verdrahtungsschicht geteilt ist,

   welche nur eine Signalverdrahtung (93) aufweist, die zum Übertragen bidirektionaler Signale an zumindest ein Element gestaltet ist; und in eine zweite Verdrahtungsschicht, welche nur eine Hauptleistungsquellenverdrahtung (94) aufweist, die zum Liefern von Leistung an eine Vielzahl von Elementen der Halbleitervorrichtung gestaltet ist; wobei das Material, das zum Bilden der Hauptleistungsquellenverdrahtung (94) verwendet ist, einen höheren Widerstand gegenüber Elektromigration aufweist, als das Material, das zum Bilden der Signalverdrahtung (93) verwendet ist.

2. Halbleitervorrichtung nach Anspruch 1, wobei der Widerstand der Verdrahtungsschicht mit nur der Signalverdrahtung (93) geringer ist als derjenige der Verdrahtungsschicht mit der Hauptleistungsquellenverdrahtung (94).

3. Halbleitervorrichtung nach Anspruch 1, wobei die Verdrahtungsschicht mit der Hauptleistungsquellenverdrahtung (126a, 126b) die Oberfläche der Mehrschichtverdrahtung bedeckt.

4. Halbleitervorrichtung nach Anspruch 1, wobei die erste Verdrahtungsschicht (93) unter der zweiten Verdrahtungsschicht (94) liegt.

5. Verfahren zum Herstellen einer Halbleitervorrichtung mit einer Mehrschichtverdrahtung zum Liefern von Leistungs- und Steuersignalen an Elemente der Vorrichtung mit folgenden Schritten:

Bilden einer ersten Verdrahtungsschicht (94) für nur bidirektionale Signalverdrahtung;
Bilden einer isolierenden Schicht (92) auf der ersten Verdrahtungsschicht (94); und
Bilden einer zweiten Verdrahtungsschicht (93) oberhalb der ersten Verdrahtungsschicht (94) zum Führen von Gleichstromleistungssignalen, wobei die zweite Verdrahtungsschicht (93) aus einem Material gebildet wird, das einen geringeren Widerstand gegenüber Elektromigration als das Material aufweist, welches zum Bilden der ersten Verdrahtungsschicht (94) verwendet wird.

## Revendications

1. Dispositif à semiconducteur incluant un câblage multicouche pour appliquer des signaux d'alimentation et de commande sur des éléments dudit dispositif, le câblage multicouche étant divisé selon une première couche de câblage comprenant:

un câblage de signal seulement (93) conçu pour transmettre des signaux bidirectionnels à au moins un élément; et
une seconde couche de câblage comprenant un câblage de source d'alimentation seulement (94) conçu pour alimenter une pluralité d'éléments dudit dispositif à semiconducteur,
dans lequel le matériau utilisé pour former le câblage d'alimentation (94) présente une résistance à l'électromigration supérieure à celle du matériau utilisé pour former le câblage de signal (93).

2. Dispositif à semiconducteur selon la revendication 1, dans lequel la résistivité de la couche de câblage comprenant seulement le câblage de signal (93) est inférieure à celle de la couche de câblage comprenant le câblage d'alimentation (94).

3. Dispositif à semiconducteur selon la revendication 1, dans lequel la couche de câblage comprenant le câblage d'alimentation (126a, 126b) recouvre la surface du câblage multicouche.

4. Dispositif à semiconducteur selon la revendication 1, dans lequel ladite première couche de câblage (93) est située sous ladite seconde couche de câblage (94).

5. Procédé de fabrication d'un dispositif à semiconducteur comprenant un câblage multicouche pour appliquer des signaux d'alimentation et de commande sur des éléments dudit dispositif, comprenant les étapes de:

formation d'une première couche de câblage (94) pour un câblage de signal bidirectionnel seulement;
formation d'une couche d'isolation (92) sur ladite première couche de câblage (94); et
formation d'une seconde couche de câblage (93) au-dessus de ladite première couche de câblage (94) pour transporter des signaux d'alimentation courant continu, dans lequel ladite seconde couche de câblage (93) est formée par un matériau présentant une résistance à l'électromigration inférieure à celle du matériau utilisé pour former ladite première couche de câblage (94).

FIG.1. Prior Art

$$C_S = \frac{\varepsilon_S W}{T_{ox}}$$

FIG.2(a) Prior Art

$$C_S = C_{S1} + 2C_{S2}$$

FIG.2(b) Prior Art

FIG.3(a)

FIG.3(b)

FIG.3(c)

FIG.3(d)

FIG 3(e)

FIG.3(f)

FIG.4(a)

FIG.4(b)

FIG.5.

FIG.6(a)        FIG.6(b)        FIG.6(c)        FIG.6(d)

FIG.6(e)        FIG.6(f)        FIG.6(g)

FIG.6(h)

FIG.7(a)

FIG.7(b)

FIG.8.

EP 0 574 097 B1

Samples : 40

Temp. = 250°C

$J = 2.0 \times 10^6 A/cm^2$

$f = 1KHz$

AC

DC

hour

Number of Aℓ wirings remaining without disconnection

FIG.9.

14

FIG.10.

FIG.11.

FIG.12.